# EUROPEAN PATENT APPLICATION

(11) **EP 4 711 893 A1**
(43) Date of publication of application: **18.03.2026**
(21) Application number: 25200132.6
(22) Date of filing: 04.09.2025
(51) Int. Cl.: G06F 1/20, H05K 7/20

(54) **SYSTEM AND METHOD FOR ENERGY SAVING CONTROL OF THERMAL MANAGEMENT**

(30) Priority: 13.09.2024 US 202463694348 P
(71) Applicant: Vertiv Corporation, Westerville, OH 43082 (US)
(72) Inventor: MAISTRO, Massimiliano, Westerville, 43082 (US)
(74) Representative: Cousens, Nico

(57) **Abstract**

A direct-to-chip (D2C) cooling system maintains microchip assemblies within their optimal junction temperature ranges by circulating liquid coolant into contact with the microchip assemblies for heat transfer therefrom. A coolant distribution unit (CDU) controller directly monitors (via a power distribution unit supplying operating power to the servers) power drawn by each of a set of servers, switches, or other information technology (IT) devices and/or microchip assemblies disposed therein, determining on a continual basis which IT device is currently drawing the most power and directing the CDU of the D2C system to dynamically adjust the flow rate setpoint for the liquid coolant supply based on the current highest power draw.

## Description

### CROSS-REFERENCE TO RELATED APPLICATIONS

The present application claims the benefit under 35 U.S.C. § 119(e) of U.S. Provisional Patent Application Serial Number 63/694,348 filed September 13, 2024, titled SYSTEM AND METHOD FOR ENERGY SAVING CONTROL OF THERMAL MANAGEMENT.

### TECHNICAL FIELD

The present disclosure is directed generally to the field of thermal management for data centers and other enclosed or interior spaces, and particularly to management of direct-to-chip (D2C) thermal management systems.

### BACKGROUND

Applications such as generative artificial intelligence (Al) and other like algorithms and applications require high performance CPUs and GPUs in order to run smoothly, effectively, and rapidly. To this end, data center chips may incorporate upwards of, e.g., 80 billion (80,000,000,000) transistors per chip, which translates into increased thermal design power (TDP), or the maximum amount of heat generated by the chip, all of which must be dissipated regardless of workload. For example, assuming almost 100% of silicon's TDP is converted into heat, the heat flux per cm² of such high-performance, high-density chips is increasing past the point where air cooling alone is effective. Single-phase direct-to-chip (D2C) liquid cooling is a viable solution for heat collection and dissipation whereby dedicated coolant distribution units (CDU) deliver liquid coolant at a set flow rate and temperature to coldplates or heat exchangers proximate to the chip. However, flow rate and supply temperature are conventionally driven by peak IT load and maximum chip temperature, and as the IT load varies over time, the flow rate exceeds what is needed.

### SUMMARY

In a first aspect, a computer-assisted method for direct-to-chip (D2C) thermal management is disclosed. In embodiments, the method includes providing a cluster of servers, switches, or other information technology (IT) devices, where each IT device includes one or more microchip assemblies. The method includes providing operating power to each IT device of the cluster via a power distribution unit (PDU). The method includes regulating the junction temperature of each microchip assembly by circulating a liquid coolant through the microchip assemblies of the cluster via a coolant distribution unit (CDU) and according to a flow rate setpoint. The method includes monitoring, via power sensors within the PDU, at least two power draws from two or more different IT devices within the cluster. The method includes determining the highest or greatest power draw among the measured power draws, e.g., the server determined to be drawing the most operating power. The method includes adjusting, via the CDU controller, the coolant flow rate setpoint based on the determined highest power draw to maintain the highest drawing microchip assembly or server, as well as any microchip assembly or server having a lower power draw, below its maximum junction temperature.

In some embodiments, the method includes increasing the coolant flow rate based on the determined highest power draw.

In some embodiments, the controller (subsequent to the current measurement of power draws) measures additional (subsequent) sets of two or more power draws corresponding to two or more IT devices within the cluster (which may be the same IT devices as the previous set of power draws, or a different subset of IT devices). The method includes determining the highest subsequent power draw, e.g., the highest measured power draw among the subsequently collected set of power draws.

In some embodiments, where the highest subsequent power draw is associated with a decrease in flow rate setpoint (e.g., a lower highest power draw than the last or most recently monitored highest power draw), the controller maintains the flow rate setpoint as adjusted based on the initial highest power draw for not less than a threshold duration,

In some embodiments, where the highest subsequent power draw is associated with a further increase in flow rate setpoint (e.g., a still higher power draw than the last or most recently monitored highest power draw), the controller further increases the flow rate setpoint based on the subsequent highest power draw.

In some embodiments, the CDU circulates liquid coolant through the IT devices /microchip assemblies according to the flow rate setpoint as well as a supply temperature setpoint. For example, the controller may adjust the supply temperature setpoint as well as the flow rate setpoint based on the determined highest power draw.

In a further aspect, a system for D2C thermal management is disclosed. In embodiments, the system includes a coolant distribution unit (CDU) controller connected to a power distribution unit (PDU) supplying operating power to a cluster of servers, switches, or other IT devices, each IT device including one or more microchip assemblies. The CDU regulates the temperature of each microchip assembly, e.g., maintains the microchip assembly below its maximum junction temperature, by circulating liquid coolant through the microchip assemblies according to a predetermined coolant flow rate. The system includes power sensors (e.g., within the PDU) for monitoring the operating power drawn by each IT device (e.g., or at least two different IT device of the cluster), and reporting the set of measured power draws to the controller. For each set of measured power draws, the controller determines a highest power draw among the set, and adjusts the coolant flow rate based on the determined highest power draw, e.g., to ensure that the IT device or microchip assembly associated with the highest power draw is maintained under its maximum junction temperature, along with all other IT devices or microchip assemblies currently drawing less power.

In some embodiments, the controller increases the flow rate setpoint based on the determined highest power draw.

In some embodiments, the set of two or more measured power draws are initial power draws, and the power sensors measure a subsequent set of power draws, e.g., from the same or a different set of IT devices but at a time subsequent to the initial set of measured power draws. The controller then determines the highest power draw from among the subsequent set of two or more power draws.

In some embodiments, the subsequent highest power draw is associated with a decrease in flow rate (e.g., relative to the initial highest power draw), but the controller maintains the flow rate setpoint associated with the initial highest power draw for at least a threshold duration (e.g., before decreasing the flow rate).

In some embodiments, the subsequent highest power draw is associated with a further increase in flow rate (e.g., relative to the initial highest power draw), and the controller immediately further increases the flow rate setpoint based on the subsequent highest power draw.

In some embodiments, the coolant flow rate setpoint may be adjusted between a maximum and minimum flow rate, the maximum based on a peak workload among the cluster of IT devices and the minimum based on a minimum required flow rate associated with one or more IT devices within the cluster.

In some embodiments, the CDU regulates junction temperatures of the microchip assemblies by adjusting the coolant supply temperature as well as the coolant flow rate. For example, based on a determined highest power draw, the controller may adjust the coolant supply temperature setpoint as well as the coolant flow rate setpoint.

In some embodiments, the environment includes multiple clusters of IT devices. For example, the system may include a network switch connecting the CDU controller to multiple PDUs, each PDU supplying a cluster of IT devices. The CDU controller may monitor junction temperatures within each cluster individually (e.g., where each cluster may be associated with different maximum junction temperatures, coolant flow rate setpoints, and/or coolant supply temperature setpoints), or treat multiple clusters as a single group of IT devices and/or microchip assemblies.

In some embodiments, the PDU supplies operating power to IT devices via a set of sockets, and the power sensors are socket-level sensors disposed within each socket of the PDU and sensing a power draw of the IT device plugged into that socket.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE DRAWINGS

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a diagrammatic illustration of a direct-to-chip (D2C) cooling system environment for a set of IT devices and/or microchip assemblies according to example embodiments of the inventive concepts disclosed herein;
FIG. 2 is a block diagram of a microchip assembly of the D2C cooling system environment of FIG. 1;
FIG. 3 is a block diagram illustrating dynamic thermal management operations of the D2C system environment of FIG. 1; and
FIGS. 4A through 4C are process flow diagrams corresponding to a computer-assisted method for dynamic D2C thermal management according to example embodiments of the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

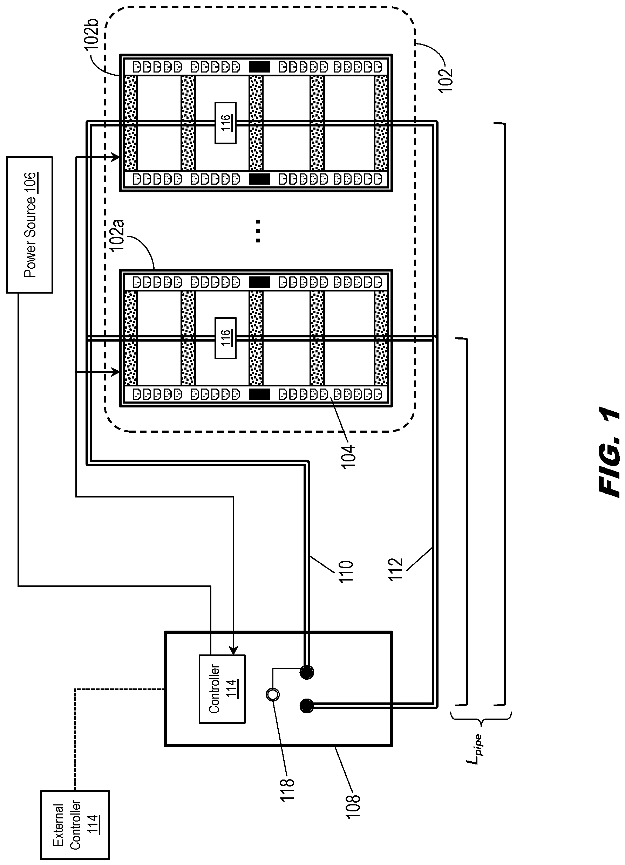

### FIG. 1 - ENVIRONMENT

Broadly speaking, embodiments of the inventive concepts disclosed herein are directed to a system and computer-assisted method for energy-efficient single-phase direct-to-chip (D2C) thermal management of servers, switches, and/or other IT devices. The response time of D2C coolant distribution units (CDU) to changes in IT loads, and corresponding changes in microchip junction temperatures (***Tⱼ***), may be delayed based on a variety of factors. For example, thermal resistances between the microchip assembly proper (where junction temperature is measured) and liquid coolant supplied by the CDU may introduce delay. Further, the physical distance between the CDU and the microchip assembly may introduce additional delay. These associated sources of delay complicate the CDU's response to rapid increases in junction temperature, e.g., as associated with sudden rapid increases in IT load due to generative Al or like algorithm processing. The system avoids these delays by directly monitoring the power draw to each server and identifying the greatest current power draw. The CDU may then be directed to adjust coolant flow rate and/or supply temperature based on the chip or server associated with the highest power draw, even though the highest power draw may not represent a maximum possible power draw or junction temperature. By continual monitoring of power draws by each microchip assembly or server, the CDU dynamically and immediately adjusts the coolant flow and supply temperature to maintain each microchip beneath its temperature threshold (above which clock frequency and processing performance may be adversely affected). However, by adjusting the flow rate or supply temperature based on a current local maximum (as opposed to, e.g., an overly conservative estimate anticipating a possible delay in response time), the CDU may avoid expending more energy than is necessary to maintain all microchips below their temperature thresholds. For example, given a technology cooling loop (TCL) served by a CDU, the TCL including a cluster of servers and/or microchip assemblies, each server may comprise a single microchip assembly or multiple microchip assemblies. In any event, the CDU may adopt the lowest threshold temperature among the cluster as a local maximum below which all clusters, servers, and/or microchip assemblies are to be maintained.

Referring to FIG. 1, a data center environment 100 is shown. The environment 100 may include one or more racks, sets or clusters 102 of servers, switches, or any other appropriate information technology (IT) devices 102a-102b; one or more power distribution units 104 (PDU; also rack PDU (rPDU)) for supplying operating power to the IT devices 102a-102b (e.g., via a power source 106); a coolant distribution unit 108 (CDU) for circulating a liquid coolant (e.g., fluid refrigerant, water or a like working fluid; single-phase or two-phase/phase change fluids) through the IT devices via supply piping 110 and return piping 112 (or through microchip assemblies 116 thereof, as described below); and a controller 114 (e.g., CDU controller) for managing the CDU 108. In some embodiments, the environment 100 may include an external controller 114a, e.g., connected to and controlling one or more CDUs 108 within the environment.

In embodiments, each IT device 102a-102b may incorporate one or more microchip assemblies 116 within. For example, air cooling systems remove heat generated within the data center environment 100 by circulating chilled air through the IT devices 102a-102b, whereby heat is transferred from the servers to the circulating air, and whereby the heated air is directed away from the environment for removal of the transferred heat (and subsequent re-circulation of the chilled air). Direct-to-chip (D2C) liquid cooling systems, however, transfer heat from the microchip assemblies 116 more directly, and more efficiently, via a liquid manifold and indirect contact with cold plates (as described in greater detail below). For example, D2C cooling systems as implemented by the data center environment 100 direct a liquid coolant, via the CDU 108, through the supply piping 110 and across the microchip assemblies 116 at a predetermined flow rate and supply temperature. Further, heat generated by each microchip assembly 116 (e.g., assuming a total or near-total conversion of supplied operating power into thermal energy by each microchip assembly) is transferred to the liquid coolant, which is circulated away from the IT devices 102a-102b and back to the CDU 108 via the return piping 112, where transferred heat is removed from the liquid coolant and the re-chilled coolant once again circulated to the servers. Liquid coolant returning to the CDU 108 via the return piping 112 may arrive at a return temperature, wherein deltas or differences between return temperature and supply temperature may be indicative of the CDU cooling capacity.

In embodiments, increases in IT loads managed by the IT devices 102a-102b result in increased operating power supplied by the PDU 104 and a corresponding increase in clock frequency and junction temperature ***T_{J}*** within each microchip assembly 116. For example, each microchip assembly 116 may have a specific junction temperature threshold. If a temperature threshold is exceeded, clock frequency within the microchip assembly 116 (and correspondingly chip performance) is drastically reduced as a built-in protection. In a conventional D2C system, the CDU 108 detects these increases in junction temperature via supply temperature sensors within the CDU. For example, an increase in supply temperature (***T₂ₐ*** ≈ ***T_{SS}**,* where ***T_{SS}*** is a supply temperature setpoint adjustable by the CDU 108) of the liquid coolant may be interpreted by the CDU as an increase in junction temperature, to which the CDU responds by increasing the flow rate of the liquid coolant supply and/or the supply temperature.

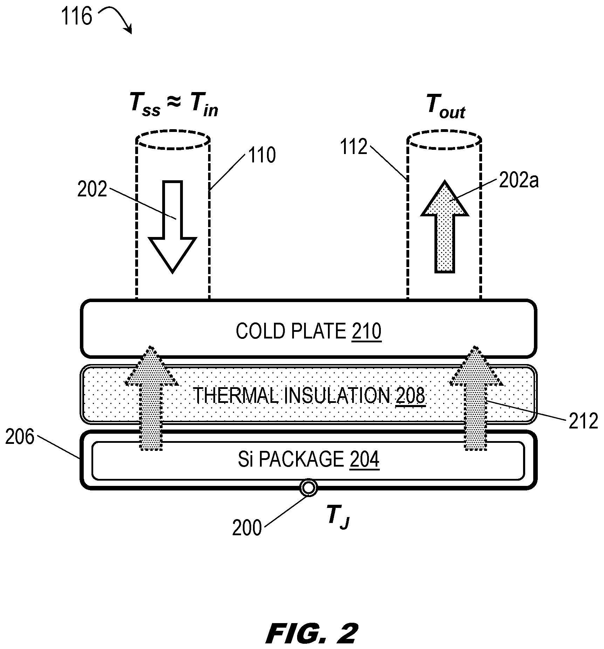

In embodiments, under steady state conditions the delta ***ΔT*** between the junction temperature ***T_{J}*** and the supply temperature setpoint Tss may be a constant function of resistances ***R_{chip}*** within the microchip assembly 116 and resistance ***Rₛₑₙₛₒᵣ*** associated with the supply temperature sensor 118 within the CDU 108. As noted above (and as shown in greater detail below by FIG. 2), resistances ***R_{chip}*** within each microchip assembly 116 introduce delay into the response time of the CDU 108. Further, the CDU 108 may be remotely located relative to the IT devices 102a-102b, e.g., outside the data center environment 100 proper or at a distance therefrom. Accordingly, liquid coolant returning to the CDU 108 from the IT devices 102a-102b must travel through the return piping 112 over a distance ***Lₚᵢₚₑ*** between the IT devices 102a-102b and the CDU 108, such that the delta ***ΔT = Δ (T_{J}, T_{SS})*** = ***f (R_{chip}*** + ***Rₛₑₙₛₒᵣ*** + ***Lₚᵢₚₑ),*** wherein the distance ***Lₚᵢₚₑ*** associated with the return piping112 introduces significant additional delay that may adversely affect the response time of the CDU to spikes or rapid variations in IT load.

In embodiments, the controller 114 may eliminate delays associated with ***R_{chip}*** and ***Lₚᵢₚₑ*** by directly sensing a power draw to each IT devices 102a-102b and/or microchip assembly 116 supplied by the power source 106 via the PDU 104. For example, when rapid increases or shifts in IT loads require rapid changes in power consumption by one or more IT devices 102a-102b and/or microchip assemblies thereof, the controller 114 may detect these changes immediately and direct a response by the CDU 108 (e.g., an adjustment to the flow rate setpoint, and possibly the supply temperature setpoint Tss, of the liquid coolant) without waiting for the CDU's temperature sensors 118 to detect and acknowledge the changes.

### FIG. 2 - CHIP ASSEMBLY THERMAL RESISTANCES

Referring now to FIG. 2, a microchip assembly 116 within an IT device server (102a-102b, FIG. 1) is shown.

In embodiments, each microchip assembly 116 may have a specified junction temperature ***(T_{J})*** range, e.g., between a minimum and maximum (e.g., sink) junction temperature (e.g., 80°C ≤ ***T_{J}*** ≤ 100°C) within which chip performance should not be adversely affected. For example, as noted above ***ΔT** = **Δ (T_{J},** Tss)* may include a parameter ***R_{chip}*** accounting for the presence of thermal resistances within the microchip assembly 116 disposed between the junction 200 and the liquid coolant 202 (e.g., circulated via supply and return piping 110, 112 respectively) and which affect the responsiveness of the CDU (108, FIG. 1) to rapid spikes or shifts in IT loads.

In embodiments, the microchip assembly 116 may additionally include silicon package 204, microchip enclosure 206, thermal insulation material 208 (TIM), and coldplate/s 210. For example, the coldplates 210 may directly transfer heat (212) from the microchip assembly 116 to the liquid coolant 202 (whereby, e.g., the liquid coolant 202a may return to the CDU 108 at a higher temperature than the supply temperature setpoint ***T_{SS}*** of liquid coolant 202 leaving the CDU), but the coldplates may provide some amount of resistance by virtue of their thickness. Similarly, the microchip enclosure 206 encasing the silicon package 204 may be no more than a fraction of a millimeter thick, but the silicon package itself, as well as the TIM 208, may each contribute some portion of ***R_{chip}**.*

In addition to ***R_{chip}*** and ***Lₚᵢₚₑ*** (e.g., based on the distance or length of return piping 112 between the IT devices 102a-102b and the CDU 108), other parameters may further affect the responsiveness of the CDU to rapid spikes or shifts in IT load, e.g., the time constant of the CDU temperature sensor 118 (FIG. 1) and/or CDU proportional/integral/derivative (PID) control parameters/deadband over the setpoint Tss.

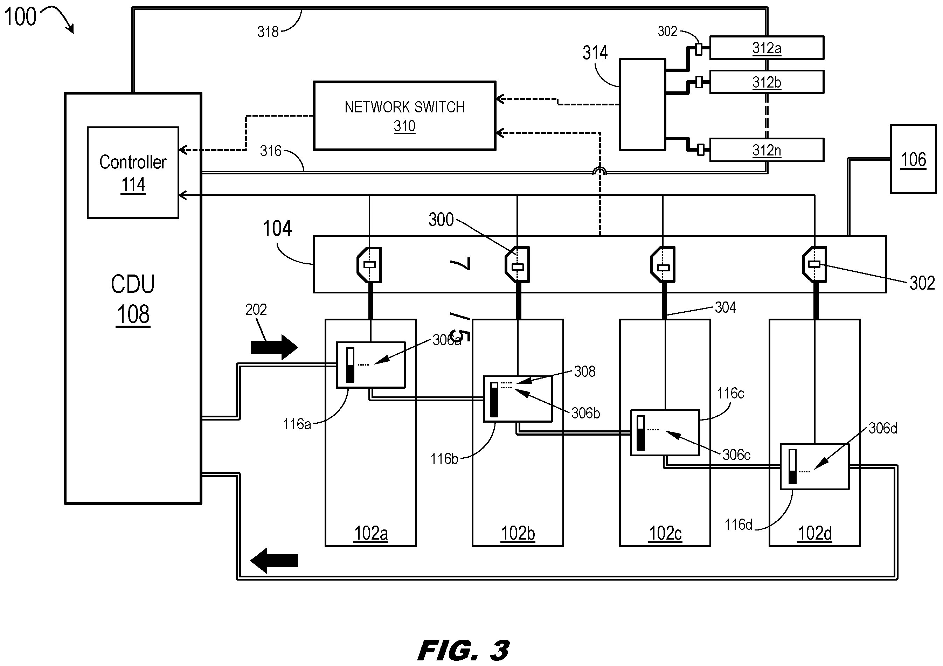

### FIG. 3 - CDU SCHEMATIC

Referring now to FIG. 3, the data center environment 100 is shown. In embodiments, IT devices 102a-102d (and the respective microchip assemblies 116a-116d disposed therewithin) may be implemented and may operate similarly to the IT devices 102a-102b shown by FIG. 1.

In embodiments, the controller 114 may bypass responsiveness delays associated with, e.g., ***R_{chip}**, **Rₛₑₙₛₒᵣ,*** and/or ***Lₚᵢₚₑ*** as outlined above by directly monitoring power consumption by each microchip assembly 116a-116d and/or IT device 102a-102d. Further, according to the real-time power drawn by each IT device 102a-102b and/or microchip assembly 116a-116d thereof, the controller 114 may continually direct the CDU 108 to adjust its flow rate setpoints and/or supply temperature setpointsTss. For example, each IT device 102a-102d may include one or more microchip assemblies 116a-116d served by a D2C cooling system, such that the CDU 108 pipes liquid coolant 202 (e.g., water or some other single-phase or two-phase fluid) via supply piping 110 according to the current flow rate setpoint and supply temperature setpoint Tss. Further, the liquid coolant 202 may be directed through the network of IT devices 102a-102d and into contact with each microchip assembly 116a-116d, returning to the CDU 108 via return piping 112 at an elevated temperature after absorbing heat from the microchip assemblies.

In embodiments, each IT device 102a-102d may draw operating power from a power source 106 via the rPDU 104, into which each server may be connected via rPDU sockets 300 (e.g., C13, C19, or any other applicable socket type). For example, each socket 300 of the rPDU 104 may include socket-level power sensors 302 capable of sensing the power draw to each IT device 102a-102d, e.g., the IT device plugged into that socket.

In embodiments, control logic within the controller 114 may continually receive power draw data (e.g., periodic concurrent sets of power drawn by each active IT device 102a-102d) from each power sensor 302 of the rPDU 104 (and any other rPDUs operating within the data center environment 100 and/or under the controller 114, e.g., via Ethernet or similar network connection). For example, the controller 114 may identify each IT device 102a-102d associated with a measured power draw, e.g., via IP address of the server, and determine for each concurrent set of two or more power draws which IT device 102a-102d is currently drawing the highest amount of power. The IT device 102b, for example, may be responsible for a significantly higher power draw 306b than the power 306a, 306c, 306d respectively drawn by IT devices 102a, 102c, or 102d.

In embodiments, the controller 114 may direct the CDU 108 to adjust the flow rate setpoint and/or supply temperature setpoint Tss governing the flow of liquid coolant 202 to the IT devices 102a-102d based on the highest current power draw 306b associated with the IT device 102b. For example, if the highest power draw 306b represents a sudden increase in clock frequency with respect to the IT device 102b, an increase in coolant flow rate (and/or a decrease in coolant supply temperature) can be expected to rapidly offset any increase in junction temperature ***T_{J}*** with respect to that IT device 102b while maintaining the IT devices 102a, 102c, 102d (e.g., all of which are currently drawing less power, indicative of lower clock frequency and/or a lower junction temperature) within their respective junction temperature ranges. Further, while a CDU 108 may be programmed for overly conservative maintenance of the junction temperatures of the microchip assemblies 116a-116d, e.g., by adjusting flow rate and/or supply temperature setpoints based on a maximum possible power draw 308, the controller 114 may likewise prevent the unnecessary expenditure of excess energy by dynamically adjusting the flow rate and/or supply temperature setpoints based on the actual sensed maximum power draw 306b rather than the maximum power draw 308, such that at any time the CDU 108 may provide liquid coolant 202 at a sufficient flow rate and/or supply temperature to maintain the IT device 102b currently drawing the most power (and therefore generating the most heat) within its junction temperature range, while also maintaining the IT devices 102a, 102c, 102d currently drawing less power (and therefore generating less heat). Accordingly, over time the controller 114 may maintain for the CDU 108 a maximum and minimum flow rate setpoint as a linear function of power drawn by the IT devices 102a-102d, e.g., where the minimum flow rate setpoint corresponds to a minimum flow rate required by a particular IT device, and the maximum flow rate corresponds to peak workload.

In embodiments, the controller 114 may further manage the CDU 108 to avoid unnecessary long-term stress on inverter-driven pumps within the CDU. For example, critical increases in junction temperature (e.g., capable of driving a microchip assembly 116a-116d into a critical mode where clock frequency is drastically reduced) may be associated with rapid spikes or increases in IT loads. Accordingly, the controller 114 may direct the CDU 108 to increase the flow rate setpoint whenever necessary. For example, when a first concurrent set of power draw readings from the rPDU 104 indicates an increased maximum power draw 306b (corresponding to an increase in clock frequency and junction temperature, and indicative of a load spike), leading the CDU 108 to increase the flow rate setpoint, and a subsequent concurrent set of power draw readings indicates a further increase with respect to the maximum power draw, the controller 114 may again direct the CDU 108 to increase the flow rate setpoint as quickly as possible.

In embodiments, with respect to shifts rather than spikes in IT load, which shifts may result in fluctuations in the maximum power draw 306b, the controller 114 may direct the CDU 108 to maintain an increased flow rate for at least a minimum threshold duration before reducing the flow rate, even if the sensed maximum power draw continues to decrease (e.g., indicative of a reduced IT load).

In some embodiments, the CDU 108 and controller 114 may monitor multiple clusters 102 (FIG. 1) of IT devices 102a-102d. For example, the environment 100 may include a network switch 310 connecting the controller 114 to the cluster 102 of IT devices 102a-102s via the rPDU 104, but also to additional clusters of IT devices 312a, 312b ... 312n via the rPDU 314 and a separate technology control loop (TCL; e.g., supply piping 316, return piping 318). Accordingly, the controller 114 may likewise monitor the power drawn by each IT devices 312a-312n via power sensors 302, adjusting coolant flow rate and/or supply temperature as needed. In embodiments, the controller 114 may treat each cluster 102a-102d, 312a-312n as a discrete group of IT devices and/or microchip assemblies 116a-116d with its own temperature and workload parameters; alternatively, the controller 114 may monitor all IT devices 102a-102d, 312a-312n as a single group.

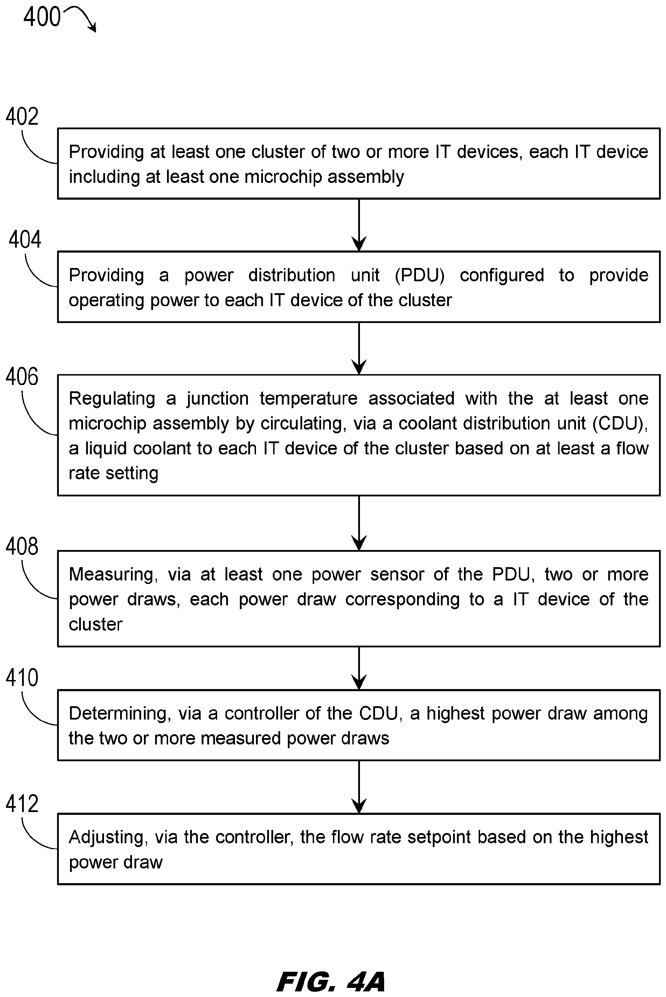

### FIGS. 4A through 4C - METHOD

Referring now to FIG. 4A, the method 400 may be implemented by the D2C system including the controller 114 and CDU 108 and may include the following steps.

At step 402, a cluster of servers, switches, or other like IT devices are provided, wherein each server includes one or more microchip assemblies configured for D2C cooling.

At step 404, a power distribution unit (PDU; also rack PDU (rPDU)) is provided such that each server of the cluster draws operating power from a power source via the PDU. In some embodiments, multiple clusters of servers are provided, e.g., each cluster connected via a PDU to a network switch, the switch in turn connected to the CDU controller. In some embodiments, each server draws operating power from a socket of the PDU, e.g., to which the server is plugged in or with which the server is otherwise engaged

At step 406, the CDU regulates the junction temperature of each server or microchip assembly (e.g., maintains the microchip assembly within a predetermined temperature range) by circulating a liquid coolant through the server or microchip assembly according to a flow rate setpoint and a supply temperature setpoint.

At step 408, power sensors disposed within or connected to the rPDU sense a power level drawn by each of the servers (or, e.g., at least two). In some embodiments, the power sensors are socket-level sensors disposed within power sockets of the PDU, e.g., dedicated to the server plugged into that socket.

At step 410, the controller receives the set of sensed power draws and determines the server currently associated with the highest power draw among the cluster of servers.

At step 412, the controller directs the CDU to adjust the flow rate setpoint based on the highest current power draw (e.g., among the current set of sensed power draws). In some embodiments, the CDU additionally or alternatively adjusts the coolant supply temperature setpoint based on the highest current power draw.

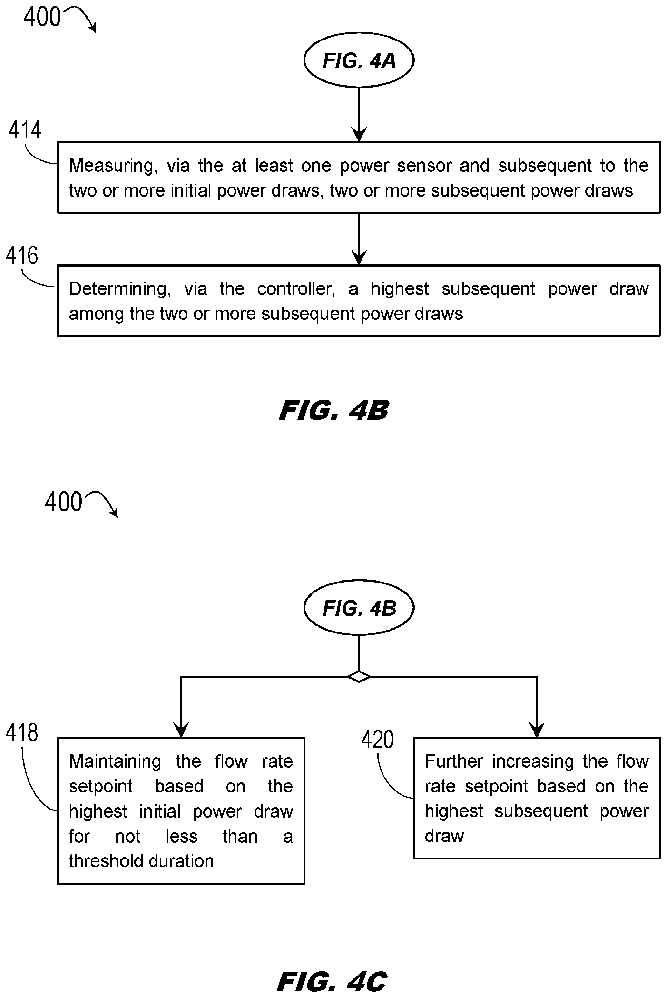

Referring also to FIG. 4B, the method 400 may include additional steps 414 and 416. At step 414, the sensors measure a subsequent set of power draws with respect to the set of servers, e.g., subsequent to the initial or most recently sensed set of power draws.

At step 416, the controller receives the subsequent set of power draws and determines the highest subsequent power draw among the subsequent set (e.g., the server currently drawing the most power at the subsequent time, which may or may not be the same server associated with the highest initial power draw in the most recently received set of sensed power draws).

Referring also to FIG. 4C, the method 400 may include additional stems 418 and 420. At step 418, when the most recently determined highest power draw results in the CDU increasing the flow rate setpoint, but the current highest power draw is associated with a decrease in highest power draw (indicative of a reduction in load and suggesting a reduction in flow rate setpoint), the controller may direct the CDU to maintain the current flow rate setpoint for at least a minimum threshold duration before reducing the flow rate setpoint.

At step 420, however, when the most recently determined highest power draw resulted in the CDU increasing the flow rate setpoint and the current highest power draw is associated with a further increase in highest power draw (indicative of a further increase in flow rate setpoint), the controller may direct the CDU to immediately increase the flow rate setpoint again.

It is contemplated that embodiments of the inventive concepts disclosed herein may have numerous advantages. For example, as noted above, the controller enables the CDU to respond immediately to rapid spikes or shifts in IT loads (and the corresponding increases in junction temperature) rather than waiting for these shifts to be detected via the supply temperature. Further, the controller can maintain each microchip assembly below its particular temperature threshold without expending unnecessary energy in anticipation of future temperature shifts.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various embodiments of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one embodiment, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the embodiments disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative embodiment of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein. Furthermore, it is to be understood that the invention is defined by the appended claims.

## Claims

1. A computer-assisted method for direct-to-chip thermal management, the method comprising:
providing (402) at least one cluster of two or more information technology "IT" devices, each IT device including at least one microchip assembly;
providing (404) a power distribution unit "PDU" configured to supply operating power to each IT device of the cluster;
regulating (406) a junction temperature associated with the at least one microchip assembly by circulating, via a coolant distribution unit "CDU" 108, a liquid coolant to each IT device of the cluster based on at least a flow rate setpoint;
measuring (408), via at least one power sensor of the PDU, two or more power draws, each power draw corresponding to an IT device of the cluster;
determining (410), via a controller of the CDU, a highest power draw among the two or more measured power draws; and
adjusting (412), via the controller, the flow rate setpoint based on the highest power draw.

2. The computer-assisted method of Claim 1, wherein the adjusting comprises:
increasing the flow rate setpoint based on the highest power draw.

3. The computer-assisted method of Claim 2, wherein the highest power draw is a highest initial power draw, and the two or more power draws are two or more initial power draws, the method further comprising:
Measuring (414), via the at least one power sensor and subsequent to the two or more initial power draws, two or more subsequent power draws; and
Determining (416), via the controller, a highest subsequent power draw among the two or more subsequent power draws.

4. The computer-assisted method of Claim 3, wherein the highest subsequent power draw is associated with a decrease of the flow rate setpoint, the method further comprising:
maintaining (418) the flow rate setpoint based on the highest initial power draw for not less than a threshold duration.

5. The computer-assisted method of Claim 3 or 4, wherein the highest subsequent power draw is associated with an increase of the flow rate setpoint, the method further comprising:
further increasing (420) the flow rate setpoint based on the highest subsequent power draw.

6. The computer-assisted method of any preceding Claim, wherein the regulating comprises:
circulating, via a coolant distribution unit "CDU", a liquid coolant to the at least one microchip assembly based on at least one of the flow rate setpoint or a supply temperature setpoint; and
wherein the adjusting comprises:
adjusting, via the controller, at least one of the flow rate setpoint and the supply temperature setpoint based on the highest power draw.

7. A system for direct-to-chip thermal management, the system comprising:
a controller (114) associated with a coolant distribution unit "CDU" (118) and operatively coupled to a power distribution unit "PDU" (104) associated with a cluster (102) of information technology "IT" devices (102a-102b), wherein the CDU is configured to regulate a temperature of at least one microchip assembly (116) disposed within each of the cluster of IT devices by circulating a liquid coolant to the each of the cluster of IT devices based on at least a flow rate setpoint, and wherein the PDU is configured to supply operating power to each of the cluster of IT devices; and
a plurality of power sensors (302) disposed within at least one of the PDU or the cluster of IT devices, the plurality of power sensors configured to measure two or more power draws, each power draw corresponding to an IT device of the cluster,
wherein the controller is configured to:
receive the two or more measured power draws,
determine a highest power draw among the two or more measured power draws, and
adjust the flow rate setpoint based on the highest power draw.

8. The system of Claim 7, wherein the controller is configured to increase the flow rate setpoint based on the highest power draw.

9. The system of Claim 8, wherein the two or more power draws are initial power draws and the highest power draw is a highest initial power draw, and:
wherein the at least one power sensor is configured to measure two or more subsequent power draws subsequent to the two or more initial power draws,
wherein the controller is configured to determine a highest subsequent power draw among the two or more subsequent power draws.

10. The system of Claim 9, wherein:
the highest subsequent power draw is associated with a decrease in the flow rate setpoint, and
wherein the controller is configured to maintain the flow rate setpoint associated with the highest initial power draw for not less than a threshold duration.

11. The system of Claim 9 or 10, wherein:
the highest subsequent power draw is associated with a further increase in the flow rate setpoint, and
wherein the controller is configured to immediately increase the flow rate setpoint based on the highest subsequent power draw.

12. The system of any of Claims 7 to 11, wherein the flow rate setpoint is associated with at least one of:
a maximum flow rate corresponding to a peak workload of the cluster of IT devices, or
a minimum flow rate associated with at least one IT device of the cluster.

13. The system of any of Claims 7 to 11, wherein:
the CDU is configured to regulate a temperature of the at least one microchip assembly by circulating the liquid coolant to the at least one microchip assembly based on at least a flow rate setpoint or a supply temperature setpoint; and
wherein the controller is configured to adjust at least one of the flow rate setpoint and the supply temperature setpoint based on the highest power draw.

14. The system of any of Claims 7 to 11, wherein the PDU is a first PDU and the cluster is a first cluster, further comprising:
at least one network switch (310) operatively coupled to the CDU; and at least one second PDU associated with a second cluster of IT devices,
wherein the controller is operatively coupled to the at least one second cluster via the at least one second PDU.

15. The system of any of Claims 7 to 11, wherein:
the PDU is configured to supply operating power to each of the cluster of IT devices via a plurality of sockets (300);
and
the at least one power sensor includes a power sensor disposed within each of the plurality of sockets.
